# EUROPÄISCHE PATENTSCHRIFT

(11) **EP 1 869 956 B1**
(45) Veröffentlichungstag und Bekanntmachung des Hinweises auf die Patenterteilung: **03.12.2014**
(21) Anmeldenummer: 06723050.8
(22) Anmeldetag: 17.02.2006
(51) Int. Cl.: H05K 5/00, H01R 9/24

(54) **GERÄT**
DEVICE
DISPOSITIF

(30) Priorität: 01.04.2005 DE 102005015318
(43) Veröffentlichungstag der Anmeldung: 26.12.2007
(73) Patentinhaber: SEW-EURODRIVE GmbH & Co. KG, 76646 Bruchsal (DE)
(72) Erfinder: DAMINGER, Franz, 76694 Forst (DE); LANGHAUSER, Steffen, 76199 Karlsruhe (DE)
(86) Internationale Anmeldenummer: PCT/EP2006/001435
(87) Internationale Veröffentlichungsnummer: WO 2006/102955

(56) Entgegenhaltungen:
- EP-A- 0 942 637
- DE-A1- 10 332 392
- DE-A1-102005 014 021
- DE-U1- 29 723 178

## Beschreibung

Die Erfindung betrifft ein Gerät.

Elektrische Geräte, die in industriellen Anlagen im Feld eingesetzt werden, sind auch Schmutz, Staub, Wasser und anderen Stoffen ausgesetzt. Beim Installieren, Anschließen von Leitungen oder anderen Wartungsarbeiten kommt es vor, dass das Gerät geöffnet werden muss. Nachteilig sind oft die schlechten Lichtverhältnisse und auch der Schmutz, die ein einfaches und schnelles sowie korrektes abnehmen und wieder Verbinden von Teilen des Gehäuses mit dem Rest erschweren.

Aus der DE 103 32 392 A1, das die Merkmale des Oberbegriffs von Anspruch 1 zeigt, ist ein Feldgerät bekannt, dessen Oberteil mittels Führungsschiene abhebbar ist von einem Unterteil, wobei das Abheben umständlich und aufwendig ist.

Aus der DE 297 23 178 U1 ist ein elektronisches Gerät bekannt, das eine zur Vorderseite des Geräts hin gerichtete Führungsschiene aufweist. Das Abziehen des Vorderteils geschieht hierbei von Hand.

Aus der EP 0 942 637 A ist eine Steuerungsanlage mit Führungen bekannt, die T-Nutenförmig ausgeführt sind. Das Oberteil wird dabei von Hand abgehoben vom Unterteil.

Aus der DE 10 2005 014 021 A1 ist eine Vorrichtung bekannt, die ein Unterteil aufweist, auf das ein Oberteil aufsetzbar ist, wobei im Unterteil Anschlussvorrichtungen angeordnet sind.

Der Erfindung liegt daher die Aufgabe zugrunde, die Installation, Wartung und Reparatur zu erleichtern.

Erfindungsgemäß wird die Aufgabe bei dem Gerät nach den in Anspruch 1 angegebenen Merkmalen gelöst.

Wesentliche Merkmale der Erfindung bei dem Gerät sind, dass es zumindest ein Oberteil umfasst, das auf ein Unterteil aufsetzbar ist,

wobei das Oberteil einen Raumbereich für mindestens eine elektronische Schaltung und das Unterteil mindestens einen Raumbereich für Anschlussvorrichtungen umfasst,

wobei das Oberteil ein Steckverbinderteil umfasst und das Unterteil ein entsprechendes Gegensteckverbinderteil,

wobei eine Führungsschiene vorgesehen ist zur Verhinderung von Kippbewegungen des Oberteils gegen das Unterteil beim Verbinden des Steckverbinderteils des Oberteils und des entsprechenden Gegensteckverbinderteils des Unterteils.

Von Vorteil ist dabei, dass das Oberteil schnell und einfach austauschbar ist und dabei die Steckverbinderteile des Oberteils und Unterteils ohne Kippbewegung ineinander hineingeführt werden. Es ist also eine sogenannte blinde Betätigung beim Verbinden ausführbar, also ein Verbinden ohne Sichtkontakt. Dabei ist das Ineinanderfügen der Steckverbinderteile sicher gewährleistet.

Gemäß der Erfindung ist die Führungsschiene mittels Flachkopfschrauben in von einem Blechteil umfasste Langlöcher mit aufgeweiteten Bereichen einschiebbar, insbesondere in Richtung der Normale der Rückseite des Unterteils. Insbesondere ist das Unterteil mittels der Flachkopfschrauben in engere Bereiche der Langlöcher einschiebbar. Von Vorteil ist dabei, dass die Führungsschiene in einfacher Weise schnell und sicher in ein Blechteil einhängbar ist. Dies ist auch bei schlechten Lichtverhältnissen einfach und sicher ausführbar. Das Blechteil stellt als lösbare verbindbare Verbindung die Schnittstelle zu einer Vorrichtung, wie Wand, Maschinenteil, Anlagenteil oder dergleichen, dar.

Bei einer vorteilhaften Ausgestaltung ist ein Befestigungsmittel zur kraftschlüssigen Verbindung der Führungsschiene mit dem Blechteil vorgesehen. Von Vorteil ist dabei, dass die Führungsschiene unverschiebbar mit dem Blechteil verbindbar ist nach Anziehen des Befestigungsmittels und somit gesichert montierbar ist.

Bei einer vorteilhaften Ausgestaltung verläuft die Oberkante des Unterteils von der Rückseite zur Vorderseite hin schräg abnehmend, insbesondere zur Erreichung eines möglichst kleinen Betätigungswinkels für die unterste Anschlussvorrichtung.

Alternativ ausgedrückt, nimmt die Höhe des Unterteils von der Rückseite zur Vorderseite hin ab.

Von Vorteil ist dabei, dass ein möglichst kleiner Betätigungswinkel für die unterste Anschlussvorrichtung erreichbar ist. Denn die an der Unterseite im Innenraum des Unterteils positionierte Anschlussvorrichtung ist mit der Hand oder mit einem Werkzeug zwar auch bei einem Quaderförmigen Unterteil erreichbar. Jedoch ist der Winkel gegen die Horizontale bei der schrägen Ausführung geringer. Wichtig ist dabei, dass die Betätigung des Geräts von der Vorderseite her geschieht. Dies ermöglicht den Einbau des Gerätes in eine Umgebung, in welcher Begrenzungen des Raumbereichs um das Gerät herum an allen anderen Seiten vorhanden sind. Beispielsweise ist das Gerät mit seiner Rückseite an eine Wand oder Ähnliches montiert. Diese ist also nicht zugänglich. Die Zugänglichkeit des Gerätes von oben oder von den beiden seitlichen Seiten ist ebenfalls begrenzt durch benachbart angebrachte Vorrichtungen, wie Schutzzäune, Kästen, Maschinenteile oder dergleichen. Im Wesentlichen ist also das Gerät voll betätigbar, auch wenn es nur von der Vorderseite her zugänglich ist. Unter Betätigung wird insbesondere auch das Herstellen von elektrischen Verbindungen durch Einführen von Kabeln ins Unterteil und Verbinden der Kabel an Anschlussvorrichtungen, wie Klemmen, Klemmleisten, Lüsterklemmen, Schneidklemmen und viele weitere im Stand der Technik bekannte Anschlussvorrichtungen, verstanden. Meist ist zur Betätigung auch das Drehen einer Schraube an der Anschlussvorrichtung oder ein Drücken eines Teils der Anschlussvorrichtung mit dem Schraubendreher notwendig. Auch ein Löten kann zur Betätigung gehören. Das jeweilige Werkzeug ist bei der Erfindung von der Vorderseite her gut einführbar, weil das Unterteil schräg ausgeführt ist und somit der Betätigungswinkel kleiner ist als bei quaderförmiger Ausführung. Der minimale Betätigungswinkel ist durch die Schrägung verkleinerbar.

Bei dem Gerät handelt es sich vorteiligerweise um ein industrielles Gerät zum dezentralen Einsatz in einer Anlage. Die elektronische Schaltung ist also als Steuerung mit Ein- und Ausgängen und/oder als Umrichter zur Versorgung eines Elektromotors und/oder als Motorschalter und/oder als Sanftanlaufgerät für einen Elektromotor ausführbar. Sie ist abgedichtet im Oberteil vorgesehen. Auch die elektrische Übergabevorrichtung, wie Steckverbinder oder dergleichen, ist entsprechend abgedichtet ausgeführt. Auch die Herausführung von Licht mittels optischer Leiter ist ebenso dicht ausgeführt. Die Abdichtung ist derart gut ausgeführt, dass die elektronische Schaltung wasserdicht und luftdicht gegen den Raumbereich der Anschlussvorrichtungen angeordnet ist.

Darüber hinaus ist auch der Raumbereich der Anschlussvorrichtungen abgedichtet gegen die Umgebung ausgeführt. Dazu ist auch das Oberteil und das Unterteil mittels einer Dichtung abgedichtet verbindbar. Der Raumbereich der Anschlussvorrichtungen ist gegen die Umgebung auch abgedichtet. Jedoch ist ein Herstellen einer so hohen Schutzart und Dichtheit wie bei der elektronischen Schaltung nicht vorgesehen. Denn die Anschlussvorrichtungen sind nicht derart empfindlich wie die Bauteile der elektronischen Schaltung. Somit sind Kosten einsparbar. Denn eine absolute Luftdichtheit und Wasserdichtheit muss für die Anschlussvorrichtungen nicht hergestellt werden. Es genügt beispielsweise ein Spritzwasserschutz für die Anschlussvorrichtungen. Etwas Luftfeuchtigkeit kann in den Raumbereich der Anschlussvorrichtungen eintreten ohne Gefahr der Zerstörung für diese. Für die elektronische Schaltung gilt dies aber nicht. Daher ist hier eine luftdichte Abdichtung vorgesehen.

Bei einer vorteilhaften Ausgestaltung ist die Leiterplatte vertikal orientiert. Von Vorteil ist dabei, dass die Leiterplatte im Bereich der Rückseite des Unterteils anordenbar ist. Denn diese Rückseite ist höher als die seitlichen Seiten und die Vorderseite. Somit ist die Leiterplatte groß ausführbar, jedoch nicht derart groß, dass sie den vertikal auszuführenden Hub zum Trennen des Unterteils und des Oberteils bestimmt. Dieser Hub ist nur durch andere Komponenten bestimmt, wie Dichtung und/oder Steckverbinder.

Bei einer vorteilhaften Ausgestaltung weist die Vorderseite eine geringere Höhe auf als die Rückseite des Unterteils und das Oberteil ist entsprechend schräg ausgeführt. Von Vorteil ist dabei, dass die Zugänglichkeit mit einem Werkzeug zur untersten Anschlussvorrichtung besser ist als bei einem Gerät, dessen Unterteil an der Vorderseite eine gleich hohe Oberkante aufweist wie an der Rückseite.

Bei einer vorteilhaften Ausgestaltung ist zwischen Oberteil und Unterteil eine Dichtung angeordnet, welche das Oberteil von außen und das Unterteil von innen umgibt. Von Vorteil ist dabei, dass Wasser von oben kommend nicht in den Bereich der Dichtung laufen kann sondern um den Bereich der Dichtung herum geleitet wird.

Bei einer vorteilhaften Ausgestaltung sind Anschlussvorrichtungen des Unterteils auf einer Leiterplatte angeordnet. Von Vorteil ist dabei, dass die Fertigung automatisiert ausführbar ist und somit kostengünstig.

Bei einer vorteilhaften Ausgestaltung ist die Rückseite des Gerätes mit einer Führungsschiene verbunden. Von Vorteil ist dabei, dass der Hub geführt ausführbar ist und dabei Kippbewegungen des Oberteils verhinderbar sind.

Bei einer vorteilhaften Ausgestaltung umfasst das Oberteil mindestens ein Steckverbinderteil und das Unterteil mindestens das entsprechende Gegensteckverbinderteil. Von Vorteil ist dabei, dass handelsübliche Steckverbinderteile verwendbar sind und somit alle elektrischen Verbindungen mit einer einfach und kostengünstig gestalteter Übergabesteckervorrichtung ausführbar sind.

Bei einer vorteilhaften Ausgestaltung ist mittels der Führungsschiene das Oberteil vom Unterteil um einen Hub abhebbar, währenddessen Ausführung Steckverbinderteil und Gegensteckverbinderteil verbindbar oder trennbar sind und wobei der Hub gleich oder größer ist als der für das Verbinden oder Trennen notwendige Hub. Von Vorteil ist dabei, dass der Hub so bemessen sein kann, dass das Verbinden und Trennen ohne Kippbewegung ausführbar ist. Weitere Komponenten, wie beispielsweise Leiterplatten und/oder Anschlussvorrichtungen, beeinflussen die Größe des minimal notwendigen Hubs nicht.

Bei einer vorteilhaften Ausgestaltung ist mittels der Führungsschiene das Oberteil vom Unterteil um einen Hub abhebbar, währenddessen Ausführung die dichte Verbindung zwischen Oberteil und Unterteil lösbar ist. Von Vorteil ist dabei, dass der für die Dichtung notwendige Hub sehr viel kleiner ist als der für das Trennen und Verbinden der Steckverbinder. Somit ist der Wert des Hubs nicht beeinflusst von der Dichtung. Vorteiligerweise ist die Dichtung entsprechend ausgeführt.

Bei einer vorteilhaften Ausgestaltung weist an der Vorderseite das Oberteil eine beleuchtete Anzeige auf, wobei Lichtleiter aus dem Raumbereich der elektronischen Schaltung von dort vorhandenen Leuchtmitteln Licht zur Anzeige leiten. Von Vorteil ist dabei, dass die Anzeige im Oberteil vorsehbar ist, weil durch die Schräge im unteren Bereich Platz geschaffen ist zum Vorsehen einer Anzeige. Die Anzeige durchbricht nicht die den Raumbereich der Elektronik umgebende Haube sondern ist im Raumbereich der Anschlussvorrichtungen angeordnet. Somit ist keine Ubergabe des Lichtes von Oberteil und Unterteil nötig.

Bei einer vorteilhaften Ausgestaltung ist der Raumbereich der elektronischen Schaltung abgedichtet und/oder in hoher Schutzart ausgeführt gegen den Raumbereich der Anschlussvorrichtung und gegen die Umgebung. Von Vorteil ist dabei, dass die Elektronik großen Temperaturunterschieden ausgesetzt sein kann und trotzdem keine Luft in den Raumbereich der Elektronik eindringen kann, also auch keine Luftfeuchtigkeit.

Bei einer vorteilhaften Ausgestaltung ist ein aufklappbarer Berührschutz am Unterteil vorgesehen. Von Vorteil ist dabei, dass die Sicherheit in einfacher und kostengünstiger Weise verbesserbar ist.

Weitere Vorteile ergeben sich aus den Unteransprüchen.

Die Erfindung wird nun anhand von Abbildungen näher erläutert:

Bezeichnungen in der vorliegenden Schrift, wie unten, oben, Horizontale, vertikal, Unterseite, Oberseite, Rückseite und Vorderseite sind der besseren Verständlichkeit anhand der Zeichnungen auch in den Ansprüchen verwendet. Diese Bezeichnungen sind aber bei der vorliegenden Erfindung so zu verstehen, dass auch andere Orientierungen beim Einbau des Gerätes von der Erfindung umfasst sind. Die Bezeichnungen sind dann entsprechend ihrer Bedeutung angepasst zu verstehen.

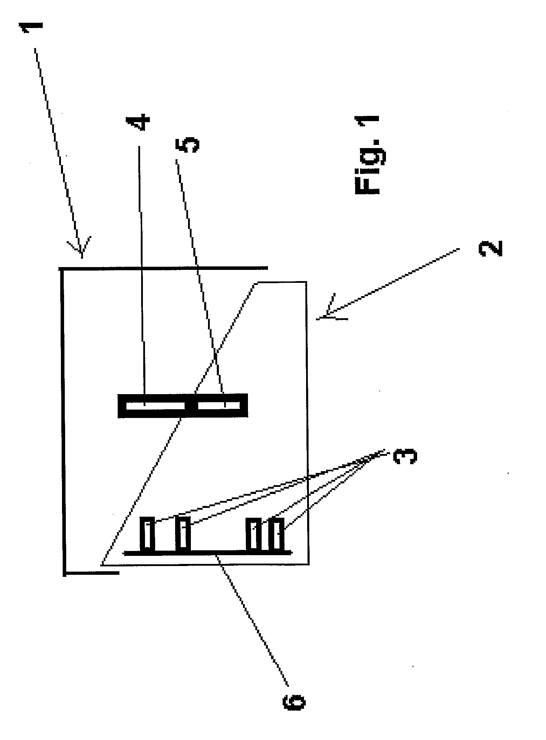

In der Figur 1 ist die erfindungsgemäße Vorrichtung symbolisch skizziert. Bei der Erfindung ist wesentlich, dass ein Oberteil 1 als Haube auf ein Unterteil 2 aufgesetzt wird. Somit fließt das Wasser außen gut ab.

Es genügt ein minimaler Hub h zum Trennen der Teile. Das Trennen erfolgt durch Ausführen des Hubs h nach oben. Danach kann die Haube 1 nach vorne abgezogen werden.

Der Hub h ist daher notwendig, weil das Oberteil 1 ein Steckverbinderteil 4 umfasst und das Unterteil 2 das entsprechenden Gegensteckverbinderteil 5 umfasst und die Steckverbinderteile in Hubrichtung ineinander gesteckt werden müssen. Außerdem ist eine in Figur 1 nicht gezeigte Führungsschiene in Richtung des Hubes h vorgesehen, die ein Verkippen des Oberteils gegen das Unterteils verhindert. Somit läuft das Ineinanderstecken der Steckverbinderteile ohne Verkanten oder andere Problematiken ab und die Reibungskräfte beim Stecken sind klein gehalten. Während der Hubbewegung wird außerdem eine nicht gezeigte Dichtung zwischen Oberteil und Unterteil aufgetrennt oder hergestellt.

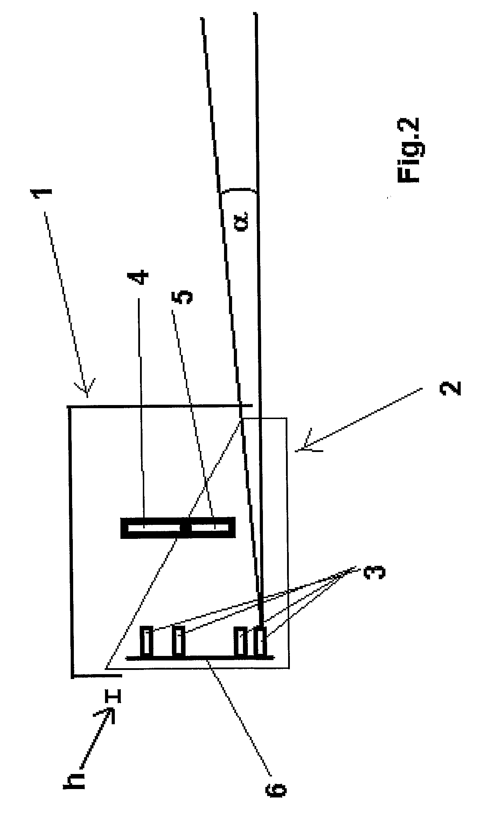

Der besondere Vorteil der Erfindung liegt in der kompakten Ausführung des Gerätes bei gleichzeitiger sehr guter Zugänglichkeit der Anschlussvorrichtungen 3 des Unterteils. Dies ist in Figur 2 angedeutet durch den minimalen Betätigungswinkel α, der beim Öffnen des Gerätes zur Verfügung steht, um mit einem Werkzeug, wie Schraubendreher oder dergleichen, eine Klemme einer Anschlussvorrichtung 3 zu betätigen. Beispielsweise ist ein Drehen einer Schraube an der untersten Anschlussvorrichtung 3 notwendig. Da die Schnittstelle des Unterteils und des Oberteils schräg ausgeführt sind, also nicht rechtwinklig, weist das Unterteil an der Vorderseite eine sehr niedrige Oberkante auf. Auf der Rückseite weist das Unterteil - wiederum der Schräge wegen - eine sehr hohe Oberkante auf.

Der minimale Betätigungswinkel α ist derart als Winkel gegen die Horizontale definiert, dass ein möglichst niedrig gehaltenes Werkzeug von der Vorderseite her in die unterste Anschlussvorrichtung eingeführt wird und dieses betätigbar ist, beispielsweise eine dort vorhandene Schraube drehbar ist mit einem Schraubendreher als Werkzeug.

Als Maß für den minimalen Betätigungswinkel α kann auch der Winkel der Verbindungslinie der Oberkante der Vorderseite zur untersten Anschlussvorrichtung gegen die Horizontale gewählt werden. Bei dem minimalen Betätigungswinkel α handelt es sich um ein praktisches Maß, das entsprechend der genauen Ausführung des Gerätes zu bestimmen ist.

Wegen dieser schrägen Ausformung des Gerätes ist es nun ermöglicht, insbesondere im rückwärtigen Teil eine große Platine vorzusehen, die insbesondere Anschlussvorrichtungen 3 aufweist. Das Steckverbinderteil 5 ist im Unterteil mechanisch gehalten und elektrisch sind Leitungen zwischen diesem Steckverbinderteil 5 und Anschlussvorrichtungen 3 vorgesehen.

Die Leiterplatte 6 ist zwar groß ausgeführt, aber nicht so groß, dass der Wert des minimal notwendigen Hubes h beeinflusst wäre. Denn die Leiterplatte 6 ist noch im Inneren des Unterteils 2 positioniert.

Durch die seitlich schräg verlaufende Gehäusekontur an der Schnittstelle zwischen Ober- und Unterteil, wo auch die Dichtung dazwischen vorgesehen ist, wird erreicht, dass das

Oberteil nur in geringem Maße angehoben werden muss, um es dann nach vorne wegnehmen zu können. Der Raumbereich oberhalb des Gerätes kann begrenzt sein durch weitere Vorrichtungen, wie Schutzzäune oder andere fest montierte Geräte. Gleichzeitig kann durch die schräge Ausführung eine gute Zugänglichkeit der Anschlussklemmen im Geräte-Unterteil gewährleistet werden.

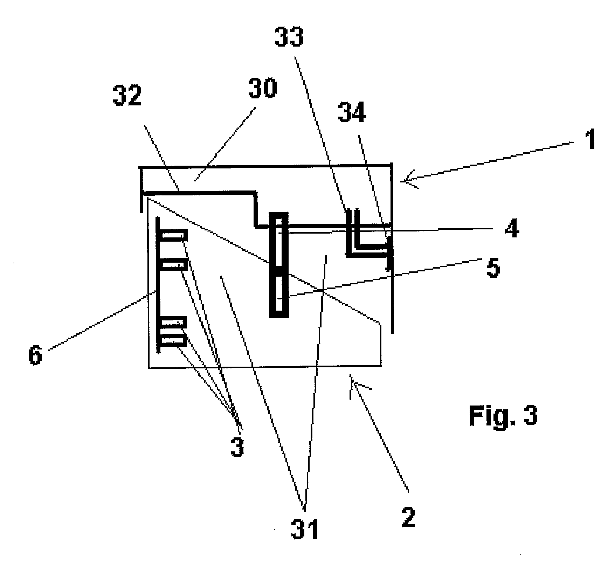

In Figur 3 ist das Doppelkammerprinzip näher gekennzeichnet. Die erste Kammer 30 ist für den Raumbereich der Elektronik vorgesehen, der von dem für die Anschlussvorrichtungen vorgesehenen Raumbereich, also von der zweiten Kammer 31 dicht und in hoher Schutzart abgetrennt ist. Die Trennlinie zwischen den Bereichen ist mit dem Bezugszeichen 32 gekennzeichnet. Zum Herstellen der hohen Schutzart sind Dichtungen vorgesehen, wobei der Bereich des Steckverbinders (4,5) ebenfalls derart abgedichtet ausgeführt ist, dass der Bereich 30 wasserdicht und auch luftdicht, also in hoher Schutzart, gegen den Bereich 31 angeordnet ist.

Infolge der Schräge kann ein Gehäuse-Durchbruch im Bereich der ersten Kammer 30 im Oberteil, der für eine Leuchtanzeige zum Anzeigen von zumindest Statusinformationen nötig wäre, weiter nach unten verlegt werden in den Raumbereich 31 der Anschlussvorrichtungen 3. Dabei ist der Gehäusedurchbruch aber noch im Oberteil vorgesehen und es muss keine Schnittstelle zur Übergabe von Lichtleitern oder dergleichen ins Unterteil vorgesehen werden. Dies ist in Figur 3 deutlich gezeigt. Im unteren Teil des Oberteils ist das Sichtfenster 34 vorgesehen, dessen Ausleuchtung mittels der Lichtleiter 33 ausgeführt ist, die vom Bereich 30 in den Bereich 31 geführt sind. Der entsprechende Durchgang durch die Berandung 32 ist ebenfalls abgedichtet und in hoher Schutzart ausgeführt. Das Sichtfenster kann auch eine Beschriftung umfassen zur Kenzeichnung der beleuchteten Felder.

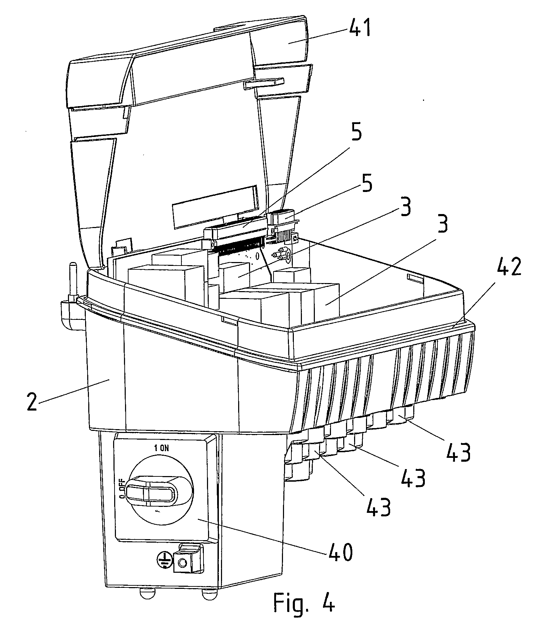

In den Figuren 4 bis 8 ist ein weiteres konkreteres erfindungsgemäßes Ausführungsbeispiel gezeigt.

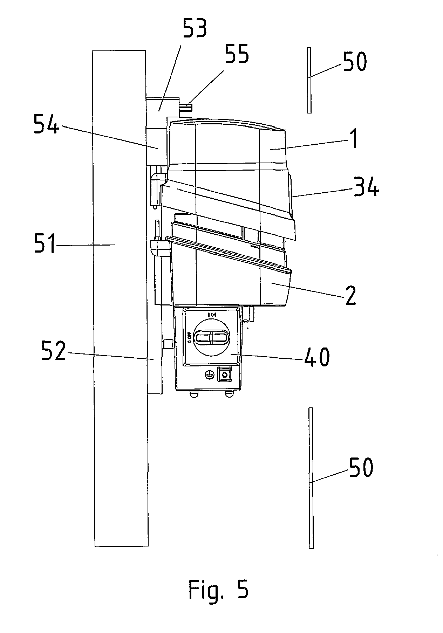

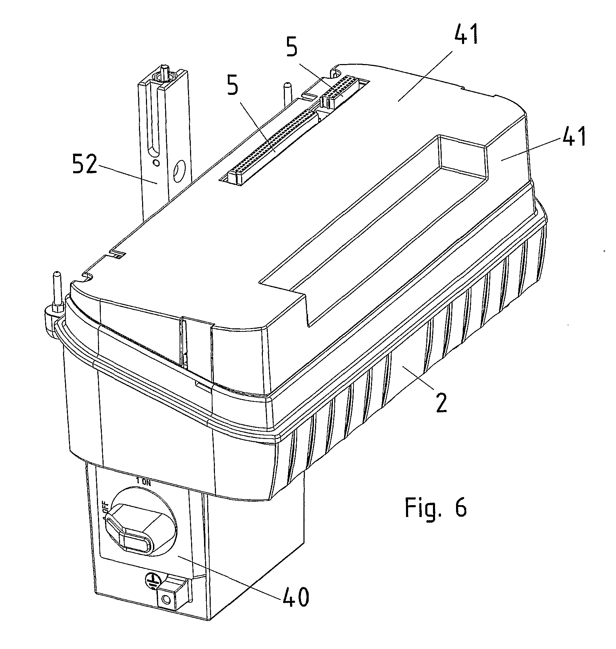

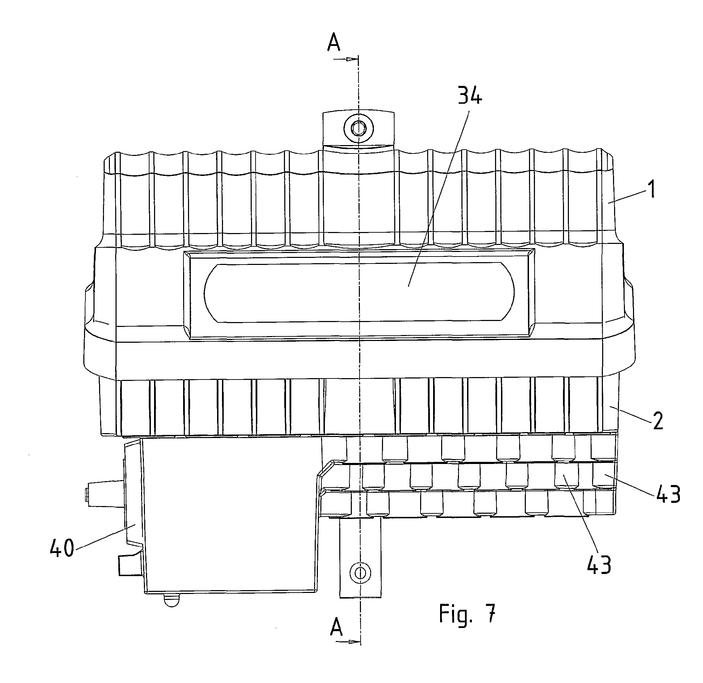

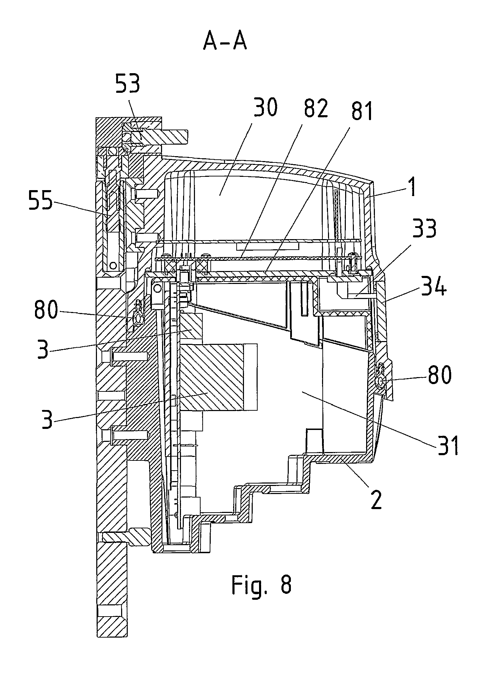

Dabei ist in der Figur 5 eine Seitenansicht des Gerätes, in der Figur 4 das Unterteil mit aufgeklapptem Berührschutz 41, in der Figur 6 das Unterteil mit geschlossenem Berührschutz 41, in der Figur 7 eine Vorderansicht und in der Figur 8 ein Schnittbild gezeigt.

Der Schutzschalter 40 dient zum Abschalten der Stromversorgung und umfasst eine Sicherung gegen Überstrom.

Der Berührschutz 41 ist aufklappbar und ist als Sicherheitselement vorgesehen. Das Unterteil weist eine Dichtfläche 42 zur Auflage der Dichtung 80, mittels welcher die dichte Verbindung des Oberteils und des Unterteils ausführbar ist.

Der Schutzzaun 50 ist im Raumbereich um das Gerät herum angebracht und wirkt begrenzend auf den Bereich der Betätigung des Geräts, insbesondere bei der Wartung. Das Gerät ist an der Wand 51 montiert. Dazu ist die Führungsschiene 52 lösbar mit der Wand mittels Schrauben verbunden. An der Führungsschiene 52 ist das Unterteil 2 angeschraubt. Das aufgesetzte Oberteil 1 ist abhebbar, indem ein Werkzeug an die Werkzeugaufnahme 55 angesetzt wird und mittels dieser der Winkeltrieb 53 betätigt wird. Dieser setzt die Drehung von der horizontalen in die vertikale Drehung um und betätigt so die Abhebevorrichtung 54, welche ein Abheben des Oberteils 1 entlang der Führungsschiene 52 ermöglicht. Nach Ausführung eines gewissen Hubes h ist das Oberteil 1 nach vorne zum Bediener aus dem Schutzzaun 50 heraus abziehbar.

Wegen der schrägen Ausführung des Unterteils 2 ist der minimale Betätigungswinkel α sehr klein und die Anschlussvorrichtungen sind daher gut zugänglich. Obwohl also der Raumbereich der Bedienung und Betätigung des Gerätes sehr klein ist, ist dem Bediener genügend viel Arbeitsraum bereit gestellt zur Betätigung des Gerätes. Dazu ist insbesondere das Herstellen der Verdrahtung an den Anschlussvorrichtungen 3 zu berücksichtigen. Denn dabei muss beispielsweise mit der Hand ein Draht in eine Anschlussvorrichtung eingesteckt werden und dann diese mit einem Schraubendreher betätigt werden.

Zwischen Oberteil und Unterteil ist zur Herstellung der dichten Verbindung und hohen Schutzart eine Dichtung 80 vorgesehen. Diese verläuft am Umfang des Gerätes entsprechend der schrägen Ausführung. Dies bedeutet, dass die Dichtung 80 an der Rückseite, also zur Wand 51 hin, höher vorgesehen ist als an der Vorderseite. An den Seitenwänden nimmt die Höhe, auf der die Dichtung 80 vorgesehen ist, von hinten nach vorne ab.

Die Leiterplatte 82 für Elektronik ist im Raumbereich 30 horizontal vorgesehen. Dadurch ist für das Sichtfenster 34 im unteren Bereich an der Vorderseite des Oberteils Platz geschaffen. Die Lichtleiter 33 versorgen das Sichtfenster 34 mit Licht von Leuchtmitteln, die auf der Leiterplatte 82 vorgesehen sind.

Ein Blech 81 ist horizontal angeordnet und dichtet den Bereich 30 vom Bereich 31 ab. Die Leiterplatte 82 für Elektronik ist mittels Schrauben in Bolzen befestigt, welche in Sacklöchern des Bleches 81 angeordnet sind.

Das Unterteil weist Ausnehmungen als Kabeldurchlass auf, in welchen PG-Verschraubungen oder entsprechende Komponenten vorgesehen sind. Durch diese Ausnehmungen sind also Energie- und Informations-Versorgungsleitungen durchführbar.

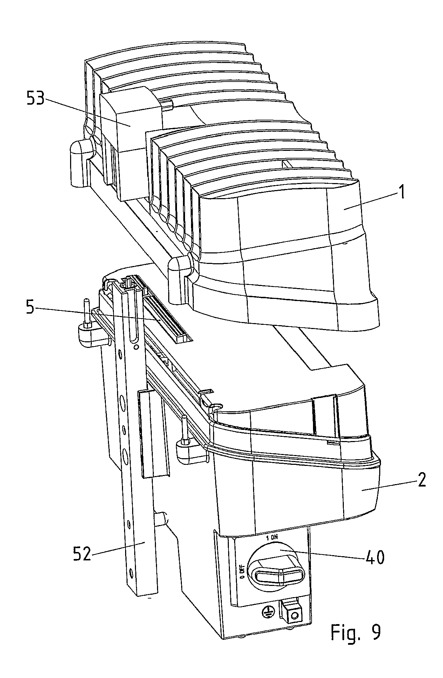

In Figur 9 ist das Aufsetzen des Oberteils 1 mittels der Führungsschiene 52 zum Herstellen der Steckverbindung mit den Steckverbindern (4,5) deutlicher gezeigt.

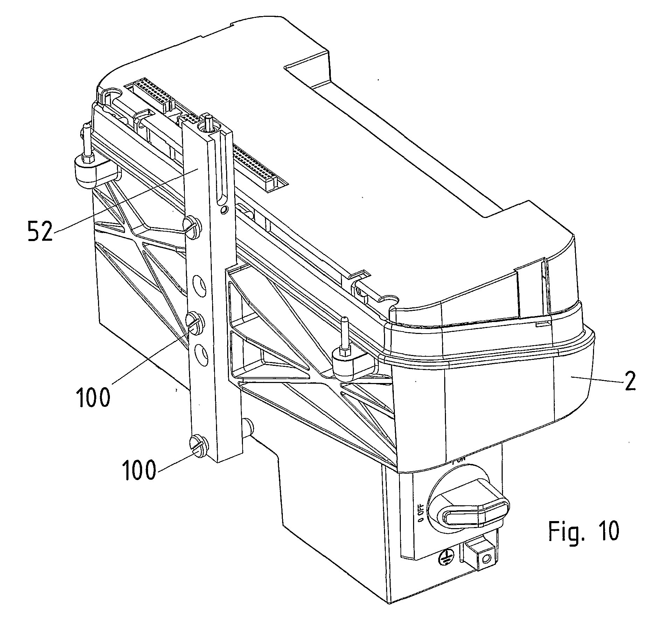

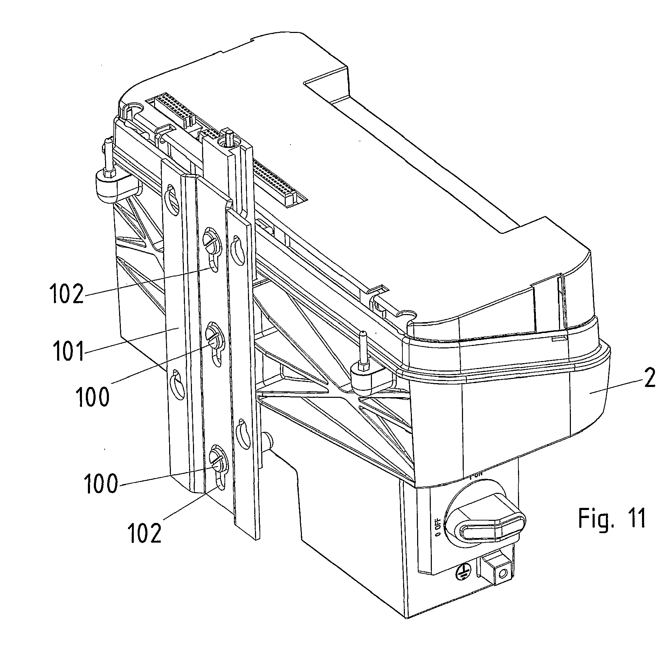

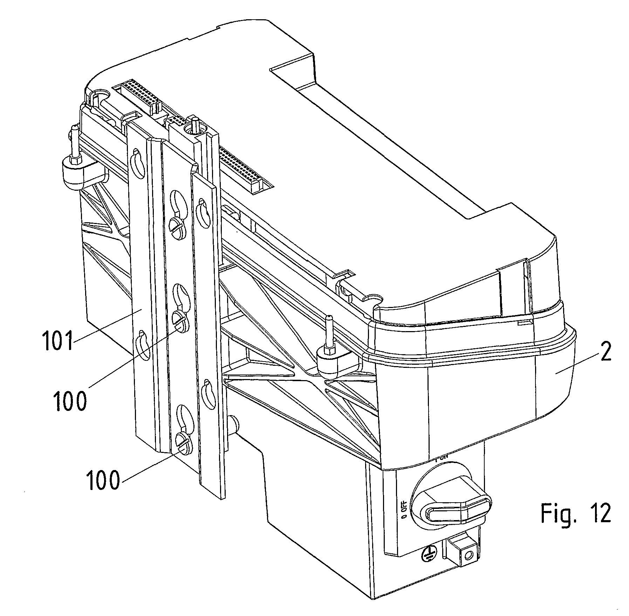

Aus Figur 10 ist ersichtlich, dass an der Rückseite der Führungsschiene 52 Flachkopfschrauben 100 einschraubbar sind, mit denen das Gerät gemäß Figur 11 in aufgeweitete Bereiche von Langlöchern 102 eines Blechteils 101 einschiebbar sind. Nach dem Einschieben wird, wie in Figur 12 gezeigt, das Gerät nach unten in die engeren Bereiche der Langlöcher 102 eingeschoben.

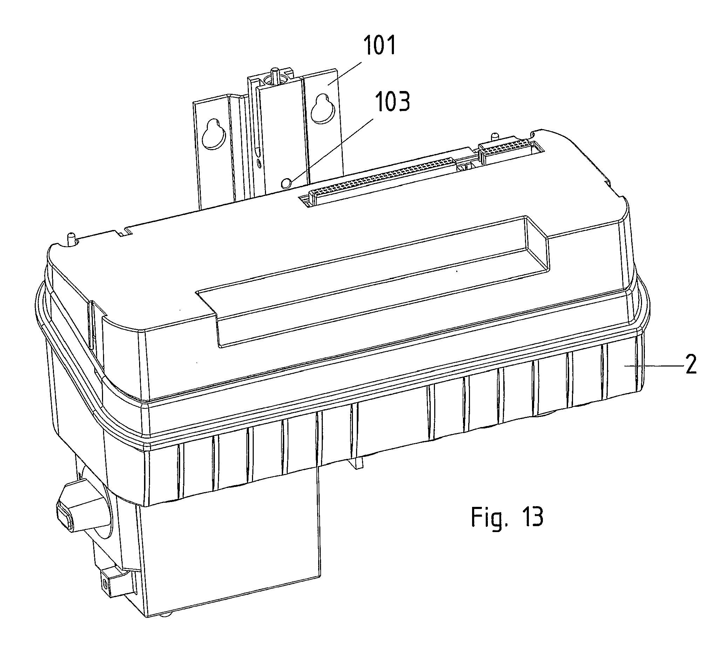

Zur sicheren Befestigung ist ein Bohrloch 103 vorgesehen, durch das ein Befestigungsmittel einbringbar ist zur kraftschlüssigen Verbindung zwischen Führungsschiene 52 und Blechteil 101, wie in Figur 13 ersichtlich.

### Bezugszeichenliste

- 1: Oberteil, Haube
- 2: Unterteil
- 3: Anschlussvorrichtungen
- 4: Steckverbinderteil des Oberteils
- 5: Entsprechendes Gegensteckverbinderteil des Unterteils
- 6: Leiterplatte
- 30: 1. Kammer, Raumbereich der Elektronik
- 31: 2. Kammer, Raumbereich der Anschlussvorrichtungen
- 32: Berandung der ersten Kammer
- 33: Lichtleiter
- 34: Sichtfenster
- 40: Schutzschalter
- 41: Berührschutz, aufklappbar
- 42: Dichtfläche zur Auflage der Dichtung 80
- 50: Schutzzaun
- 51: Wand
- 52: Führungsschiene
- 53: Winkeltrieb
- 54: Abhebevorrichtung
- 55: Werkzeugaufnahme
- 80: Dichtung
- 81: Blech
- 82: Leiterplatte für Elektronik
- 100: Flachkopfschraube
- 101: Blechteil
- 102: Langlöcher
- 103: Bohrloch zur kraftschlüssigen Verbindung zwischen Führungsschiene und Blechteil

## Patentansprüche

1. Gerät, umfassend zumindest ein Oberteil (1), das auf ein Unterteil (2) aufsetzbar ist,
wobei das Oberteil (1) einen Raumbereich für mindestens eine elektronische Schaltung und das Unterteil (2) mindestens einen Raumbereich für Anschlussvorrichtungen (3) umfasst,
wobei das Oberteil (1) ein Steckverbinderteil (4) umfasst und das Unterteil (2) ein entsprechendes Gegensteckverbinderteil (5),
wobei eine Führungsschiene (52) vorgesehen ist zur Verhinderung von Kippbewegungen des Oberteils (1) gegen das Unterteil (2) beim Verbinden des Steckverbinderteils des Oberteils (1) und des entsprechenden Gegensteckverbinderteils (5) des Unterteils (2)
wobei die Führungsschiene (52) mit dem Unterteil (2) verbunden ist,
wobei die Führungsschiene (52) mit einer Wand, einem Maschinenteil, einem Anlagenteil zur Montage des Geräts an der Wand, dem Maschinenteil, dem Anlagenteil lösbar verbindbar ist,
**dadurch gekennzeichnet, dass**
mit der Führungsschiene (52) eine Abhebevorrichtung (54) vorgesehen ist zum Abheben des Oberteils (1), die über einen Winkeltrieb (53) betätigt wird,
und dass
die Führungsschiene mittels Flachkopfschrauben (100) in von einem Blechteil (101) umfasste Langlöcher (102) mit aufgeweiteten Bereichen einschiebbar ist, insbesondere in Richtung der Normale der Rückseite des Unterteils (2).

2. Gerät nach Anspruch 1,
**dadurch gekennzeichnet, dass**
das Oberteil (1) relativ bewegbar zur Führungsschiene angeordnet und von dieser beim Bewegen geführt ist.

3. Gerät nach mindestens einem der vorangegangenen Ansprüche,
**dadurch gekennzeichnet, dass**
das Unterteil (2) mittels der Flachkopfschrauben (100) in engere Bereiche der Langlöcher (102) einschiebbar ist.

4. Gerät nach mindestens einem der vorangegangenen Ansprüche,
**dadurch gekennzeichnet, dass**
ein Befestigungsmittel zur kraftschlüssigen Verbindung der Führungsschiene mit dem Blechteil (101) vorgesehen ist.

5. Gerät nach einem der vorangehenden Ansprüche,
**dadurch gekennzeichnet, dass**
das Blechteil (101) lösbar verbindbar ist mit einer Vorrichtung, wie Wand, Maschinenteil, Anlagenteil oder dergleichen.

6. Gerät nach mindestens einem der vorangegangenen Ansprüche,
**dadurch gekennzeichnet, dass**
eine Oberkante des Unterteils (2) von der Rückseite zur Vorderseite hin schräg abnehmend verläuft, insbesondere zur Erreichung eines möglichst kleinen Betätigungswinkels für eine unterste Anschlussvorrichtung des Unterteils.

7. Gerät nach mindestens einem der vorangegangenen Ansprüche,
**dadurch gekennzeichnet, dass**
die Vorderseite eine geringere Höhe aufweist als die Rückseite des Unterteils (2) und das Oberteil (1) entsprechend schräg ausgeführt ist.

8. Gerät nach mindestens einem der vorangegangenen Ansprüche,
**dadurch gekennzeichnet, dass**
zwischen Oberteil (1) und Unterteil (2) eine Dichtung angeordnet ist, welche das Oberteil (1) von außen und das Unterteil (2) von innen umgibt,

9. Gerät nach mindestens einem der vorangegangenen Ansprüche,
**dadurch gekennzeichnet, dass**
Anschlussvorrichtungen (3) des Unterteils (2) auf einer Leiterplatte (6) angeordnet sind.

10. Gerät nach Anspruch 9,
**dadurch gekennzeichnet, dass**
die Leiterplatte (6) vertikal orientiert ist.

11. Gerät nach mindestens einem der vorangegangenen Ansprüche,
**dadurch gekennzeichnet, dass**
die Rückseite des Gerätes mit der Führungsschiene verbunden ist.

12. Gerät nach mindestens einem der vorangegangenen Ansprüche,
**dadurch gekennzeichnet, dass**
das Oberteil (1) mindestens ein Steckverbinderteil (4) und das Unterteil (2) mindestens das entsprechende Gegensteckverbinderteil (5) umfasst.

13. Gerät nach mindestens einem der vorangegangenen Ansprüche,
**dadurch gekennzeichnet, dass**
mittels der Führungsschiene das Oberteil (1) vom Unterteil (2) um einen Hub abhebbar ist, währenddessen Ausführung Steckverbinderteil (4) und Gegensteckverbinderteil (5) verbindbar oder trennbar sind und wobei der Hub gleich oder größer ist als der für das Verbinden oder Trennen notwendige Hub.

14. Gerät nach mindestens einem der vorangegangenen Ansprüche,
**dadurch gekennzeichnet, dass**
mittels der Führungsschiene das Oberteil (1) vom Unterteil (2) um einen Hub abhebbar ist, währenddessen Ausführung die dichte Verbindung zwischen Oberteil (1) und Unterteil (2) lösbar ist.

15. Gerät nach mindestens einem der vorangegangenen Ansprüche,
**dadurch gekennzeichnet, dass**
an der Vorderseite das Oberteil (1) eine beleuchtete Anzeige aufweist, wobei Lichtleiter aus dem Raumbereich der elektronischen Schaltung von dort vorhandenen Leuchtmitteln Licht zur Anzeige leiten.

16. Gerät nach mindestens einem der vorangegangenen Ansprüche,
**dadurch gekennzeichnet, dass**
der Raumbereich der elektronischen Schaltung abgedichtet und/oder in hoher Schutzart ausgeführt ist gegen den Raumbereich der Anschlussvorrichtung und gegen die Umgebung.

17. Gerät nach mindestens einem der vorangegangenen Ansprüche,
**dadurch gekennzeichnet, dass**
ein aufklappbarer Berührschutz am Unterteil (2) vorgesehen ist.

18. Gerät nach mindestens einem der vorangegangenen Ansprüche,
**dadurch gekennzeichnet, dass**
das Gerät in einer **derartig** anderen räumlichen Position einbaubar ist, **dass** dann
- das Gerät an seiner Rückseite montiert ist,
- an seiner Vorderseite zur Betätigung zugänglich ist,
- die Hubbewegung parallel zur Normalenrichtung der Unterseitenebene des Unterteils (2) auszuführen ist,
nach Ausführens der Hubbewegung zum Trennen des Unterteils (2) und des Oberteils (1) das Oberteil (1) in Richtung parallel zur Normalenrichtung der Vorderseitenebene und/oder Rückseitenebene abnehmbar ist.

## Claims

1. Apparatus, comprising at least one upper part (1) which is placeable on a lower part (2),
wherein the upper part (1) comprises a spatial region for at least one electronic circuit and the lower part (2) comprises at least one spatial region for connection devices (3),
wherein the upper part (1) comprises a plug-in connector part (4) and the lower part (2) a corresponding mating plug-in connector part (5),
wherein a guide rail (52) is provided for preventing tilting movements of the upper part (1) relative to the lower part (2) upon connection of the plug-in connector part of the upper part (1) and the corresponding mating plug-in connector part (5) of the lower part (2)
wherein the guide rail (52) is connected to the lower part (2),
wherein the guide rail (52) is detachably connectable to a wall, a machine part, a system part for mounting the apparatus on the wall, the machine part, the system part,
**characterised in that**
with the guide rail (52) there is provided a lifting-off device (54) for lifting off the upper part (1), which device is actuated via an angular drive (53),
and **in that**
the guide rail is insertable by means of flat-head screws (100) into elongated holes (102) comprised by a sheet-metal part (101) and having widened regions, in particular in the direction of the normal of the rear side of the lower part (2) .

2. Apparatus according to Claim 1,
**characterised in that**
the upper part (1) is arranged to be movable relative to the guide rail and is guided by the latter upon movement.

3. Apparatus according to at least one of the preceding claims,
**characterised in that**
the lower part (2) is insertable by means of the flat-head screws (100) into narrower regions of the elongated holes (102).

4. Apparatus according to at least one of the preceding claims,
**characterised in that**
a fastening means for force-locking connection of the guide rail to the sheet-metal part (101) is provided.

5. Apparatus according to one of the preceding claims,
**characterised in that**
the sheet-metal part (101) is detachably connectable to a device, such as a wall, machine part, system part or the like.

6. Apparatus according to at least one of the preceding claims,
**characterised in that**
an upper edge of the lower part (2) runs from the rear side towards the front side in an obliquely declining manner, in particular to achieve an actuating angle as small as possible for a lowermost connection device of the lower part.

7. Apparatus according to at least one of the preceding claims,
**characterised in that**
the front side has a smaller height than the rear side of the lower part (2), and the upper part (1) is of correspondingly oblique form.

8. Apparatus according to at least one of the preceding claims,
**characterised in that**
a seal is arranged between the upper part (1) and the lower part (2), which seal surrounds the upper part (1) from outside and the lower part (2) from inside.

9. Apparatus according to at least one of the preceding claims,
**characterised in that**
connection devices (3) of the lower part (2) are arranged on a printed circuit board (6).

10. Apparatus according to Claim 9,
**characterised in that**
the printed circuit board (6) is vertically oriented.

11. Apparatus according to at least one of the preceding claims,
**characterised in that**
the rear side of the apparatus is connected to the guide rail.

12. Apparatus according to at least one of the preceding claims,
**characterised in that**
the upper part (1) comprises at least one plug-in connector part (4) and the lower part (2) comprises at least the corresponding mating plug-in connector part (5).

13. Apparatus according to at least one of the preceding claims,
**characterised in that**
the upper part (1) is liftable off the lower part (2) by means of the guide rail by a stroke, during the execution of which the plug-in connector part (4) and the mating plug-in connector part (5) are connectable or separable and wherein the stroke is equal to or greater than the stroke required for the connecting or separating.

14. Apparatus according to at least one of the preceding claims,
**characterised in that**
the upper part (1) is liftable off the lower part (2) by means of the guide rail by a stroke, during the execution of which the sealed connection between the upper part (1) and the lower part (2) is separable.

15. Apparatus according to at least one of the preceding claims,
**characterised in that**
the upper part (1) has at the front side an illuminated display, wherein light guides from the spatial region of the electronic circuit guide light from lamps present there to the display.

16. Apparatus according to at least one of the preceding claims,
**characterised in that**
the spatial region of the electronic circuit is sealed off and/or formed with a high degree of protection from the spatial region of the connection device and from the surroundings.

17. Apparatus according to at least one of the preceding claims,
**characterised in that**
an openable touch guard is provided on the lower part (2).

18. Apparatus according to at least one of the preceding claims,
**characterised in that**
the apparatus is installable in a different spatial position such that then
- the apparatus is mounted at its rear side,
- is accessible for actuation at its front side,
- the stroke movement is to be executed parallel to the normal direction of the underside plane of the lower part (2),
after execution of the stroke movement for separating the lower part (2) and the upper part (1), the upper part (1) is removable in the direction parallel to the normal direction of the front-side plane and/or rear-side plane.

## Revendications

1. Appareil, comprenant au moins une partie supérieure (1) qui peut être posée sur une partie inférieure (2),
sachant que la partie supérieure (1) comprend un espace pour au moins un circuit électronique et que la partie inférieure (2) comprend au moins un espace pour des dispositifs de connexion (3),
sachant que la partie supérieure (1) comprend un élément d'enfichage (4) et que la partie inférieure (2) comprend un contre-élément d'enfichage (5) correspondant,
sachant qu'il est prévu un rail de guidage (52) pour empêcher tout mouvement de basculement de la partie supérieure (1) par rapport à la partie inférieure (2) lors de la connexion de l'élément d'enfichage de la partie supérieure (1) et du contre-élément d'enfichage (5) correspondant de la partie inférieure (2),
sachant que le rail de guidage (52) est assemblé à la partie inférieure (2),
sachant que le rail de guidage (52) peut être assemblé de manière amovible à une paroi, à une partie de machine ou à une partie d'installation, pour le montage de l'appareil sur la paroi, la partie de machine ou la partie d'installation,
**caractérisé en ce qu'**il est prévu avec le rail de guidage (52) un dispositif de soulèvement (54) pour soulever la partie supérieure (1), dispositif qui est actionné au moyen d'un renvoi d'angle (53),
et **en ce que** le rail de guidage peut, au moyen de vis à tête plate (100), être inséré notamment dans la direction de la normale au côté arrière de la partie inférieure (2) dans des trous oblongs (102) à zones élargies qui sont pratiqués dans une pièce de tôle (101).

2. Appareil selon la revendication 1, **caractérisé en ce que** la partie supérieure (1) est disposée à déplacement relatif par rapport au rail de guidage et est guidée par ce dernier lors de ce déplacement.

3. Appareil selon au moins une des revendications précédentes, **caractérisé en ce que** la partie inférieure (2) peut, au moyen des vis à tête plate (100), être insérée dans des zones plus étroites des trous oblongs (102).

4. Appareil selon au moins une des revendications précédentes, **caractérisé en ce qu'**il est prévu un moyen de fixation pour l'assemblage à force du rail de guidage avec la pièce de tôle (101).

5. Appareil selon l'une des revendications précédentes, **caractérisé en ce que** la pièce de tôle (101) peut être assemblée de manière amovible à un dispositif tel qu'une paroi, une partie de machine, une partie d'installation ou analogues.

6. Appareil selon au moins une des revendications précédentes, **caractérisé en ce qu'**une arête supérieure de la partie inférieure (2) s'étend en pente oblique descendante depuis le côté arrière en direction du côté avant, en particulier afin d'atteindre un angle d'actionnement minimal pour un dispositif de connexion le plus inférieur de la partie inférieure.

7. Appareil selon au moins une des revendications précédentes, **caractérisé en ce que** le côté avant présente une plus petite hauteur que le côté arrière de la partie inférieure (2), et la partie supérieure (1) est réalisée avec une oblicité correspondante.

8. Appareil selon au moins une des revendications précédentes, **caractérisé en ce qu'**un joint d'étanchéité, qui entoure la partie supérieure (1) de l'extérieur et la partie inférieure (2) de l'intérieur, est disposé entre la partie supérieure (1) et la partie inférieure (2).

9. Appareil selon au moins une des revendications précédentes, **caractérisé en ce que** les dispositifs de connexion (3) de la partie inférieure (2) sont disposés sur une carte imprimée (6).

10. Appareil selon au moins une des revendications précédentes, **caractérisé en ce que** la carte imprimée (6) est orientée verticalement.

11. Appareil selon au moins une des revendications précédentes, **caractérisé en ce que** le côté arrière de l'appareil est assemblé au rail de guidage.

12. Appareil selon au moins une des revendications précédentes, **caractérisé en ce que** la partie supérieure (1) comprend au moins un élément d'enfichage (4) et la partie inférieure (2) au moins le contre-élément d'enfichage (5) correspondant.

13. Appareil selon au moins une des revendications précédentes, **caractérisé en ce que**, au moyen du rail de guidage, la partie supérieure (1) peut être soulevée à l'écart de la partie inférieure (2) d'une course pendant l'exécution de laquelle l'élément d'enfichage (4) et le contre-élément d'enfichage (5) peuvent être connectés ou déconnectés, sachant que la course est supérieure ou égale à la course nécessaire pour la connexion ou la déconnexion.

14. Appareil selon au moins une des revendications précédentes, **caractérisé en ce que**, au moyen du rail de guidage, la partie supérieure (1) peut être soulevée à l'écart de la partie inférieure (2) d'une course pendant l'exécution de laquelle la liaison étanche entre la partie supérieure (1) et la partie inférieure (2) peut être défaite.

15. Appareil selon au moins une des revendications précédentes, **caractérisé en ce que** la partie supérieure (1) présente sur le côté avant un affichage éclairé, sachant que des guides de lumière provenant de l'espace du circuit électronique dirigent, depuis des moyens d'éclairage qui y sont présents, de la lumière vers l'affichage.

16. Appareil selon au moins une des revendications précédentes, **caractérisé en ce que** l'espace du circuit électronique est étanché et/ou réalisé avec un degré de protection élevé vis-à-vis de l'espace du dispositif de connexion et vis-à-vis de l'environnement.

17. Appareil selon au moins une des revendications précédentes, **caractérisé en ce qu'**une protection rabattable contre les contacts accidentels est prévue sur la partie inférieure (2).

18. Appareil selon au moins une des revendications précédentes, **caractérisé en ce que** l'appareil peut être installé dans une autre position spatiale telle qu'alors
- l'appareil est monté sur son côté arrière,
- l'appareil est accessible sur son côté avant aux fins d'actionnement,
- la course peut être réalisée parallèlement à la direction normale au plan du côté inférieur de la partie inférieure (2),
à la suite de l'exécution de la course pour la déconnexion de la partie inférieure (2) et de la partie supérieure (1), la partie supérieure (1) peut être enlevée dans une direction parallèle à la direction normale au plan du côté avant et/ou au plan du côté arrière.
